# EUROPEAN PATENT SPECIFICATION

(11) **EP 3 029 835 B1**
(45) Date of publication and mention of the grant of the patent: **20.02.2019**
(21) Application number: 14832688.7
(22) Date of filing: 01.07.2014
(51) Int. Cl.: H03K 17/687, H02J 50/00, H02M 1/08, H04B 1/04

(54) **HIGH-FREQUENCY RECEPTION CIRCUIT AND INSULATED SIGNAL-TRANSMISSION DEVICE**
HOCHFREQUENZ-EMPFANGSSCHALTUNG UND ISOLIERTE SIGNALÜBERTRAGUNGSVORRICHTUNG
CIRCUIT DE RÉCEPTION À HAUTE FRÉQUENCE ET DISPOSITIF D'ÉMISSION DE SIGNAL ISOLÉ

(30) Priority: 31.07.2013 JP 2013159554
(43) Date of publication of application: 08.06.2016
(73) Proprietor: Panasonic Intellectual Property Management Co., Ltd., Osaka-shi, Osaka 540-6207 (JP)
(72) Inventor: NAGAI, Shuichi, Osaka 540-6207 (JP)
(74) Representative: Eisenführ Speiser
(86) International application number: PCT/JP2014/003487
(87) International publication number: WO 2015/015708

(56) References cited:
- WO-A1-2013/065254
- JP-A- H01 300 617
- JP-A- H02 303 074
- JP-A- H02 303 074
- US-A- 4 970 420
- US-A- 5 939 927
- US-A1- 2004 232 971
- US-A1- 2014 049 297
- MORAIS R ET AL: "An activation circuit for battery-powered biomedical implantable systems", SENSORS AND ACTUATORS A, ELSEVIER SEQUOIA S.A., LAUSANNE, CH, vol. 156, no. 1, 1 November 2009 (2009-11-01), pages 229-236, XP026766055, ISSN: 0924-4247, DOI: 10.1016/J.SNA.2009.06.008 [retrieved on 2009-06-25]

## Description

### Technical Field

The present disclosure relates to a high-frequency signal reception circuit used as a gate driver circuit that drives a gate terminal of a semiconductor switching element, and an isolated signal-transmission device.

### Background Art

US 4,970,420 describes a switching circuit is provided with a power field effect
transistor having a drain terminal, a source terminal and a gate terminal. A gate resistor is connected to the gate terminal. In response to a turn-on signal, a DC gate voltage is produced between the gate resistor and the source terminal. A circuit branch having a normally-on solid state switching device is connected between the gate resistor and the source terminal. The normally-on solid state switching device is turned off in response to the turn-on signal, and enabled in the absence of the turn-on signal to improve the turnoff characteristics of the power field effect transistor.

US 2014/0049297 A1 describes a gate drive circuit includes: an input port for receiving a control signal; an output port; a capacitor connected to the output port; a modulation unit which generates (i) a first modulated signal indicating timing of a first logical value of the control signal and (ii) a second modulated signal indicating timing of at least a second logical value of the control signal; a first electromagnetic resonance coupler which wirelessly transmits the first modulated signal; a second electromagnetic resonance coupler which wirelessly transmits the second modulated signal; a first rectifier circuit which generates a first demodulated signal by demodulating the first modulated signal, and outputs the first demodulated signal to the output port; and a second rectifier circuit which generates a second demodulated signal by demodulating the second modulated signal, and outputs the second demodulated signal to the output port.

A gate driver circuit of a semiconductor switching element (hereinafter also simply designated a "switching element") refers to a circuit that drives a switching element. The gate driver circuit is a circuit that controls a semiconductor switching element on and off by applying a gate voltage to the gate terminal of the semiconductor switching element. One high-voltage switching element is the insulated gate bipolar transistor (IGBT), for example, which is a type of power semiconductor device. A typical gate driver circuit is provided with a P-type transistor and an N-type transistor at the output part. The P-type transistor operates when the switching element goes from off to on, while the N-type transistor operates when the switching element goes from on to off. In other words, when the switching element goes from on to off, the gate current of the switching element is withdrawn.

In such a gate driver circuit of a power semiconductor, the reference voltage on the output side connected to the semiconductor switching element is extremely high. For this reason, the direct current (DC) component must be isolated, or in other words the signal ground must be isolated, between the primary side into which a control signal is input into the gate driver circuit, and the secondary side from which a driving signal is output to the switching element. An electronic circuit element able to realize isolation of the DC component between the primary side and the secondary side of a gate driver circuit in this way is called a signal isolating element or a contactless signal transmitter. These are indispensable elements for driving a switching element. In addition, in an electronic circuit element having such a signal isolating function, the logic ground and the RF ground are isolated. In particular, driving a power semiconductor switching element requires a separate, isolated power source. However, an isolated power source leads to increased circuit size. For this reason, if the gate driver circuit were able to not only isolate the gate signal, but also supply isolated power to the gate of the switching element, an external isolated power source would be unnecessary, and a more compact gate driver circuit would be possible.

PTL 1 discloses a power transmission system using an open-ring electromagnetic resonance coupler for the contactless signal transmitter.

### Citation List

### Patent Literature

PTL 1: Japanese Unexamined Patent Application Publication No. 2008-067012

### Summary of Invention

### Technical Problem

In a high-frequency signal reception circuit of the related art, high-speed output of the signal is desired.

Accordingly, the present disclosure provides a high-frequency signal reception circuit and an isolated signal-transmission device able to output a signal at high speed.

### Solution to Problem

A high-frequency signal reception circuit according to an aspect of the present disclosure is
defined in claim 1.

Note that the present disclosure may also be realized as an isolated signal-transmission device equipped with a high-frequency signal reception circuit according to an aspect of the present disclosure.

### Advantageous Effects of Invention

According to a high-frequency signal reception circuit and an isolated signal-transmission device in accordance with the present disclosure, a signal may be output at high speed.

### Brief Description of Drawings

FIG. 1 is a diagram illustrating an example of a high-frequency signal reception circuit according to an embodiment.
FIG. 2 is a diagram illustrating example operation when a high-frequency signal reception circuit according to an embodiment outputs an on-voltage.
FIG. 3 is a diagram illustrating example operation when a high-frequency signal reception circuit according to an embodiment outputs an off-voltage.
FIG. 4 is a diagram illustrating an example of the temporal waveforms of output voltage and output current in a high-frequency signal reception circuit according to an embodiment.
FIG. 5 is a diagram illustrating an example of a high-frequency signal reception circuit for a large input signal according to a modification of an embodiment.
FIG. 6 is a diagram illustrating an example of an isolated signal-transmission device according to an embodiment.
FIG. 7 is a block diagram illustrating a configuration of a power transmission device of the related art.

### Description of Embodiments

### (Findings that form the basis of the present disclosure)

The inventors discovered that the following problem occurs with the related art.

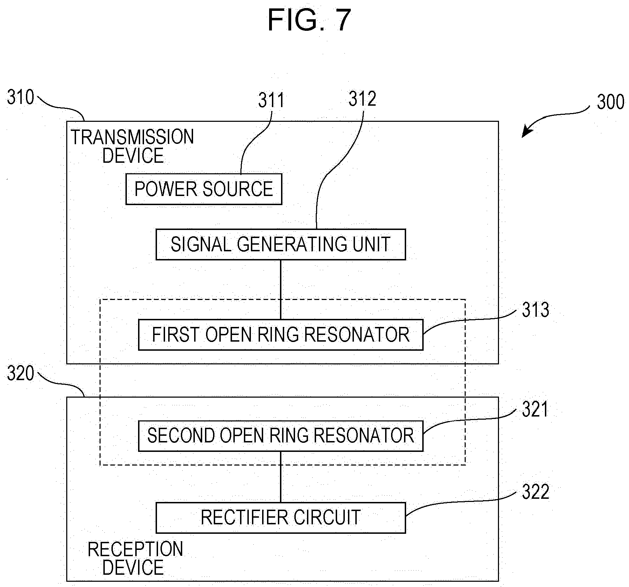

FIG. 7 is a block diagram illustrating a configuration of a power transmission device 300 in PTL 1. The power transmission device 300 is equipped with a transmission device 310 made up of a power source 311, a signal generating unit 312, and a first open ring resonator 313, and a reception device 320 made up of a second open ring resonator 321 and a rectifier circuit 322.

However, there is a problem in that such a power transmission device of the related art is unable to drive a semiconductor switching element at high speed.

In other words, in a power transmission device, it is not only desirable to supply a semiconductor switching element with power for maintaining the switching element in the on-state, but also to have a mechanism that switches the semiconductor switching element from the on-state to the off-state at high speed. A power transmission device of the related art is able to supply a gate current to the semiconductor switching element, but is unable to actively withdraw electrical charge accumulated in the gate of the semiconductor switching element. In other words, a power transmission device of the related art is able to actively switch the semiconductor switching element from the off-state to the on-state, but is unable to actively switch the semiconductor switching element from the on-state to the off-state. For this reason, lowering the semiconductor switching element at high speed is not possible. This is because a contactless signal transmitter such as the electromagnetic resonance coupler constituting the power transmission device of the related art is an element that only passively transmits power. In contrast, by providing the power transmission device with a configuration able to supply a negative voltage to the gate of the semiconductor switching element, for example, changing the semiconductor switching element to the off-state at high speed is possible. However, in this case, it is necessary to provide a circuit on a separate subsystem for supplying the negative voltage, and a signal isolating element or the like on the separate subsystem for supplying the negative voltage.

Accordingly, the present disclosure provides a high-frequency signal reception circuit and an isolated signal-transmission device capable of outputting an output signal with not only a short rising time, but also a short falling time. For example, when the high-frequency signal reception circuit and isolated signal-transmission device is applied to a gate driver circuit, a driving signal with a short rising time and falling time may be output to the semiconductor switching element to be driven. Note that a high-frequency signal reception circuit of the present disclosure may also be applied to circuits other than a gate driver circuit.

A high-frequency signal reception circuit according to an aspect of the present disclosure is defined in claim 1.

The conduction/non-conduction of the transistor provided between the output terminal and the output reference terminal is switched according to the output from the second detector circuit. Consequently, the output of the high-frequency signal reception circuit may be switched at high speed. For example, if the high-frequency signal reception circuit is connected to a semiconductor switching element, by shorting the transistor, electrical charge accumulated in the semiconductor switching element may be withdrawn.

Furthermore, an output voltage pulse to be output to the output terminal and a control voltage pulse to be output to the control terminal of the transistor are generated from a single input signal. Subsequently, when a designated negative voltage is input into the control terminal of the normally-on type transistor, the high-frequency signal reception circuit is able to output an output signal. For this reason, the high-frequency signal reception circuit is able to control the transistor so that the voltage pulse is output when the output voltage pulse is generated, and so that a voltage pulse is not output when the output voltage pulse is not generated.

In a high-frequency signal reception circuit according to an aspect of the present disclosure, for example, the input signal may be a signal including a first amplitude, and a second amplitude greater than the first amplitude. The second detector circuit, by detecting the first amplitude of the input signal, may output a first voltage value of 0 or a negative value to the control terminal of the transistor using the output reference terminal as a reference, and in addition, by detecting the second amplitude of the input signal, output a second voltage value smaller than the first voltage value to the control terminal of the transistor using the output reference terminal as a reference. The transistor may enter an off-state when the second voltage value is input into the control terminal, and enter an on-state when the first voltage value is input into the control terminal.

Consequently, the transistor is turned on and off according to the first amplitude and the second amplitude included in the input signal.

In a high-frequency signal reception circuit according to an aspect of the present disclosure, for example, the first detector circuit may output, as the output signal, a pulse signal of positive voltage to the output terminal using the output reference terminal as a reference.

A high-frequency signal reception circuit according to an aspect of the present disclosure additionally may be provided with a diode connected between the control terminal of the transistor and the output reference terminal.

Consequently, the potential of the control terminal of the transistor is adjusted. For example, when a large negative voltage is output from the second detector circuit, that voltage is output from the output reference terminal via the diode connected to the control terminal of the transistor. As a result, reduced output or a loss of output from the output terminal due to the output of the second detector circuit may be prevented.

In a high-frequency signal reception circuit according to an aspect of the present disclosure, for example, the high-frequency signal reception circuit additionally may be provided with a resistor connected between the control terminal of the transistor and the output reference terminal.

Since the resistor functions as a speed-up resistor between the control terminal of the transistor and the output reference terminal, the transistor turns on rapidly.

In a high-frequency signal reception circuit according to an aspect of the present disclosure, for example, the first detector circuit may further include, a positive diode having a cathode connected to a second terminal of the positive coupling capacitor, and an anode connected to the output reference terminal, and a positive smoothing capacitor connected between a second terminal of the positive inductor and the output reference terminal. In a high-frequency signal reception circuit according to an aspect of the present disclosure, for example, the second detector circuit may further include, a negative diode having an anode connected to a second terminal of the negative coupling capacitor, and a cathode connected to the output reference terminal, and a negative smoothing capacitor connected between a second terminal of the negative inductor and the output reference terminal.

Consequently, the first detector circuit and the second detector circuit are able to perform detection with a simple demodulation circuit using a diode and an inductor.

In a high-frequency signal reception circuit according to an aspect of the present disclosure, for example, the threshold voltage of the positive diode may be higher than the threshold voltage of the negative diode, or the on-resistance of the positive diode may be lower than the on-resistance of the negative diode.

For example, when the input signal is small, since the threshold voltage of the positive diode is higher than the threshold voltage of the negative diode, the second detector circuit is able to output a large negative voltage. For this reason, the transistor turns off reliably. For example, when the input signal is large, since the on-resistance of the positive diode is smaller than the on-resistance of the negative diode, the first detector circuit is able to output a large positive voltage. Consequently, a high-frequency signal reception circuit that operates appropriately depending on the magnitude of the input signal is realized.

Note that the positive diode and the negative diode are not required to be single elements, respectively. For example, the positive diode may also be a circuit element made up of multiple elements and having diode functionality.

An isolated signal-transmission device according to an aspect of the present disclosure, for example, is an isolated signal-transmission device that performs isolated transmission of an input signal, and is equipped with an oscillator that generates a carrier wave, a modulator that uses a pulse signal to modulate a carrier wave generated by the oscillator, an electromagnetic resonance coupler that uses electromagnetic resonance to perform isolated transmission of a modulated signal obtained by the modulator, and the above high-frequency signal reception circuit that detects a signal output from the electromagnetic resonance coupler as an input signal.

Consequently, since the isolated signal-transmission device is equipped with the above high-frequency signal reception circuit, advantageous effects similar to the above high-frequency signal reception circuit are exhibited.

Furthermore, the high-frequency signal reception circuit is able to generate an output voltage pulse to output to the output terminal and a control voltage pulse to output to the control terminal of the transistor, from a single input signal. For this reason, a more compact isolated signal-transmission device is realized, without having to provide separately a signal isolation element for the output voltage pulse and a signal isolation element for the control voltage pulse.

### (Embodiments)

Hereinafter, embodiments of the present disclosure will be described in detail using the drawings. Note that the embodiments described hereinafter all illustrate specific examples of the present disclosure. Features such as numerical values, shapes, materials, structural elements, layout positions and connection states of structural elements, steps, and the ordering of steps indicated in the following exemplary embodiments are merely examples, and are not intended to limit the present disclosure. The present disclosure is specified by the claims. Thus, among the structural elements in the following exemplary embodiments, structural elements that are not described in the independent claim indicating the broadest concept of the present disclosure are described as arbitrary or optional structural elements.

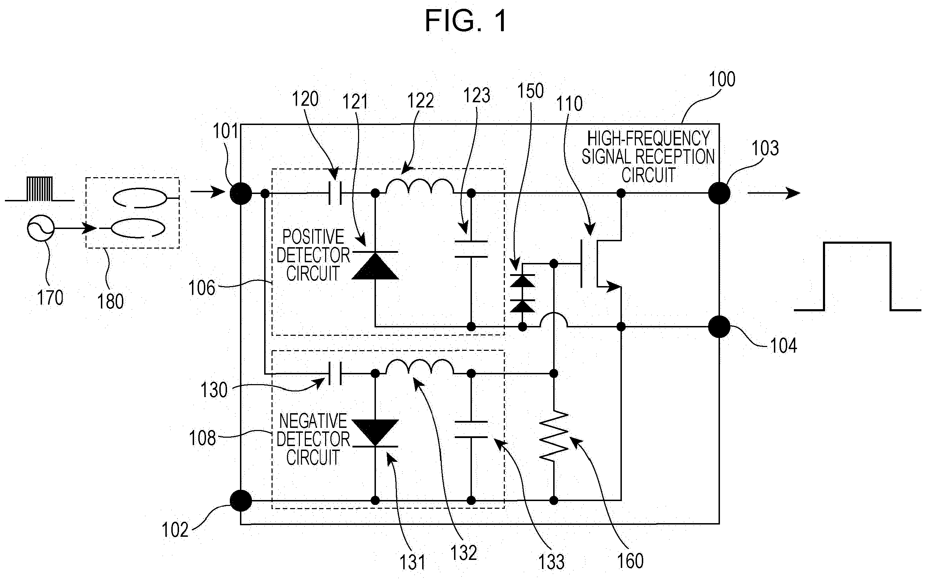

FIG. 1 is a circuit diagram illustrating an example of a high-frequency signal reception circuit 100 according to the present embodiment. The high-frequency signal reception circuit 100 is used in a gate driver circuit or the like of a semiconductor switching element. The high-frequency signal reception circuit 100 is a circuit that detects an input signal. The high-frequency signal reception circuit 100 is equipped with an input terminal 101 and an input reference terminal 102 for receiving an input signal, an output terminal 103 and an output reference terminal 104 for outputting a pulse signal after detection, a positive detector circuit 106, a transistor 110, a negative detector circuit 108, a diode 150, and a resistor 160. The input signal is a signal obtained by modulating a pulse signal onto a carrier wave. Note that FIG. 1 additionally illustrates a modulated signal generator circuit 170 and an electromagnetic resonance coupler 180, which are circuits for generating and outputting an input signal to the high-frequency signal reception circuit 100.

The modulated signal generator circuit 170 is a circuit that generates a modulated signal by modulating a pulse signal onto a carrier wave, which is a high-frequency wave.

The electromagnetic resonance coupler 180 is a contactless signal transmitter that uses electromagnetic resonance to perform isolated transmission of a modulated signal generated by the modulated signal generator circuit 170. The electromagnetic resonance coupler 180 is made up of two open rings provided opposite each other, for example. The modulated signal output from the electromagnetic resonance coupler 180 is input into the high-frequency signal reception circuit 100 as an input signal.

The input signal is a signal obtained by modulating the amplitude of the high-frequency wave that is the carrier wave according to the pulse signal, for example. The input signal has a first amplitude, and a second amplitude that is greater than the first amplitude. Although FIG. 1 illustrates a waveform of the input signal with components having voltage values of 0 V or greater, the input signal may also have a waveform with components having voltage values of less than 0. The input signal expresses a waveform that is sign-symmetric about a reference of 0 V in the envelope curve, for example. In the example illustrated in FIG. 1, the first amplitude is 0, and the second amplitude has a designated value greater than 0. In other words, in the example illustrated in FIG. 1, the period of the second amplitude of the input signal is a carrier having a frequency approximately similar to the high-frequency wave that is the carrier wave, and in which a waveform of non-zero amplitude appears, while the first period is a period with an amplitude of 0. In the present disclosure, for the sake of simplicity, the period in which the input signal expresses the second amplitude is called "when the carrier wave appears in the input signal", while the period in which the input signal expresses the first amplitude is called "when the carrier wave does not appear in the input signal" in some cases. Thus, in the example illustrated in FIG. 1, the input signal is a signal expressed by the presence or absence of the carrier wave. In addition, the input of a waveform of the input signal having the second amplitude is called "the carrier wave is input", while the input of a waveform of the input signal having the first amplitude is called "the carrier wave is not input" in some cases.

The positive detector circuit 106 is a demodulation circuit that detects an input signal input between the input terminal 101 and the input reference terminal 102, and outputs a pulse signal of positive voltage to the output terminal 103 using the output reference terminal 104 as a reference. The positive detector circuit 106 includes a positive coupling capacitor 120 with one terminal connected to the input terminal 101, a positive diode 121 whose cathode is connected to the other terminal of the positive coupling capacitor 120 and whose anode is connected to the output reference terminal 104, a positive inductor 122 with one terminal connected to the other end of the positive coupling capacitor 120, and a positive smoothing capacitor 123 connected between the other terminal of the positive inductor 122 and the output reference terminal 104.

The transistor 110 is a normally-on type transistor having a first terminal connected to the output terminal 103, a second terminal connected to the output reference terminal 104, and a control terminal. For example, the transistor may be an N-type FET. For example, the first terminal may be the drain terminal, the second terminal may be the source terminal, and the control terminal may be the gate terminal.

The negative detector circuit 108 is a demodulation circuit that detects an input signal input between the input terminal 101 and the input reference terminal 102, and outputs a pulse signal of negative voltage to the control terminal of the transistor 110 using the output reference terminal 104 as a reference. The negative detector circuit 108 includes a negative coupling capacitor 130 with one terminal connected to the input terminal 101, a negative diode 131, connected between the other end of the negative coupling capacitor 130 and the output reference terminal 104, whose anode is connected to the other terminal of the negative coupling capacitor 130 and whose cathode is connected to the output reference terminal 104, a negative inductor 132 with one terminal connected to the other end of the negative coupling capacitor 130, and a negative smoothing capacitor 133 connected between the other terminal of the negative inductor 132 and the output reference terminal 104.

The diode 150 is one or more diodes connected in series between the control terminal of the transistor 110 and the output reference terminal 104. The diode 150 is connected in the direction of current flow from the output reference terminal 104 towards the control terminal of the transistor 110.

The resistor 160 is a speed-up resistor connected between the control terminal of the transistor 110 and the output reference terminal 104.

According to the high-frequency signal reception circuit 100 provided with such a configuration, the negative detector circuit 108 outputs a pulse signal to the control terminal of the transistor 110. The pulse signal takes a negative voltage when the carrier wave appears in the input signal, and takes the reference voltage when the carrier wave does not appear in the input signal. As a result, the transistor 110 enters an off-state when a negative voltage is input from the negative detector circuit 108, and enters an on-state when the reference voltage is input from the negative detector circuit 108. Consequently, when the carrier wave appears in the input signal, the high-frequency signal reception circuit 100 outputs a positive voltage to the output terminal 103 using the output reference terminal 104 as a reference, and when the carrier wave does not appear in the input signal, the high-frequency signal reception circuit 100 shorts between the output reference terminal 104 and the output terminal 103, and outputs a ground potential to the output terminal 103 using the output reference terminal 104 as a reference.

Note that the pulse signal output by the negative detector circuit 108 includes a first voltage value and a second voltage value. The first voltage value is output as a result of the negative detector circuit 108 detecting the first amplitude of the input signal, for example. The second voltage value is output as a result of the negative detector circuit 108 detecting the second amplitude of the input signal, for example. In the example illustrated in FIG. 1, the pulse signal output by the negative detector circuit 108 expresses a first voltage value of 0, and a second voltage value of a designated negative value less than 0. Note that the first voltage value may also be negative value, while the second voltage value may be a negative value that is less than the first voltage value, for example. For example, the first voltage value is greater than the threshold voltage of the transistor 110, while the second voltage is less than the threshold voltage of the transistor 110.

Hereinafter, an example of the configuration and operation of the high-frequency signal reception circuit 100 will be discussed in further detail.

The modulated signal generator circuit 170 generates a modulated signal by performing intensity modulation (amplitude modulation) of a high-frequency wave. The modulated signal is transmitted by the electromagnetic resonance coupler 180 via contactless power transmission. The high-frequency signal reception circuit 100 treats the modulated signal as an input signal, detects the input signal, and outputs an output signal as illustrated in FIG. 1 from the output terminal 103, using the output reference terminal 104 as a reference potential. The output signal has a gate driving waveform for a semiconductor switching element, for example.

An isolated signal-transmission device equipped with the modulated signal generator circuit 170, the electromagnetic resonance coupler 180, and the high-frequency signal reception circuit 100 uses the electromagnetic resonance coupler 180 to perform contactless power transmission, or in other words, isolated transmission. For this reason, isolation is ensured between the transmitting side and the receiving side of the electromagnetic resonance coupler 180. Herein, isolation refers to electrical isolation between the signal line on the transmitting side and the signal line on the receiving side, and electrical isolation between the ground of the transmitting side and the ground of the receiving side. Also, a high-frequency wave refers to a signal used as a carrier wave, having a higher frequency than the original signal. The original signal refers to the pulse signal for modulating the carrier wave. The carrier wave has a frequency of 100 MHz or more, for example. Since the isolated signal-transmission device uses a high-frequency wave as the carrier wave, the electromagnetic resonance coupler 180, which is configured to have a resonant frequency at the frequency of that high-frequency wave, may be reduced in size. Furthermore, since the electromagnetic resonance coupler 180 is able to perform efficient power transmission even over long distances, a high dielectric strength voltage corresponding to the distance between the electromagnetic resonance couplers may be realized.

The high-frequency signal reception circuit 100 is equipped with an input terminal 101 that receives an input signal from the electromagnetic resonance coupler 180, an input reference terminal 102 connected to the ground of the electromagnetic resonance coupler 180, an output terminal 103 that outputs a signal, and an output reference terminal 104 that acts as the reference voltage of the output terminal 103. The signal output from the output terminal 103 is a gate signal supplied to the gate of a semiconductor switching element such as a power device, for example.

The positive diode 121, the positive inductor 122, and the positive smoothing capacitor 123 constituting the positive detector circuit 106 rectify an input signal input from the input terminal 101, and generate a voltage so that the cathode of the positive diode 121 takes a positive polarity using the anode as a reference.

The negative diode 131, the negative inductor 132, and the negative smoothing capacitor 133 constituting the negative detector circuit 108 rectify an input signal input from the input terminal 101, and generate a voltage so that the anode of the negative diode 131 takes a negative polarity using the cathode as a reference.

In the positive detector circuit 106, the input terminal 101 and the cathode of the positive diode 121 are connected via the positive coupling capacitor 120. The cathode of the positive diode 121 and one terminal of the positive inductor 122 are connected. The other terminal of the positive inductor 122 is connected to one terminal of the positive smoothing capacitor 123 and the output terminal 103. The other terminal of the positive smoothing capacitor 123 is connected to the anode of the positive diode 121 and the output reference terminal 104. Note that the positive detector circuit 106 may take another configuration insofar as the circuit is a detector circuit that generates a positive voltage from a modulated signal.

In the negative detector circuit 108, the input terminal 101 and the anode of the negative diode 131 are connected via the negative coupling capacitor 130. The anode of the negative diode 131 and one terminal of the negative inductor 132 are connected. The other terminal of the negative inductor 132 is connected to one terminal of the negative smoothing capacitor 133. The other terminal of the negative smoothing capacitor 133 is connected to the cathode of the negative diode 131 and the output reference terminal 104. The input reference terminal 102 is connected to the ground of the electromagnetic resonance coupler 180. Note that the negative detector circuit 108 may take another configuration insofar as the circuit is a detector circuit that generates a negative voltage from a modulated signal.

Furthermore, the output terminal 103 is connected to the drain of the transistor 110, while the output reference terminal 104 is connected to the source of the transistor 110. The gate of the transistor 110 is connected to the line or connection point at which one terminal of the negative inductor 132 and one terminal of the negative smoothing capacitor 133 are connected. Furthermore, the speed-up resistor 160 and the diode 150 for adjusting the gate potential of the transistor 110 are inserted between the gate of the transistor 110 and the source of the transistor 110.

Note that the high-frequency signal reception circuit 100 may also not be equipped with such a speed-up resistor 160 and a diode 150 for gate potential adjustment.

Herein, the transistor 110 is a normally-on type transistor, and is a transistor with a gate threshold voltage of less than 0 V. The transistor 110 is a normally-on type GaN transistor, for example. For example, the transistor 110 has a threshold of -2.5 V. In this case, the transistor is one in which when the gate voltage is 0 V using the source as a reference, the drain-source shorts, whereas when the gate voltage is -3.0 V using the source as a reference, the drain-source opens.

The transistor 110 is an N-channel transistor, for example.

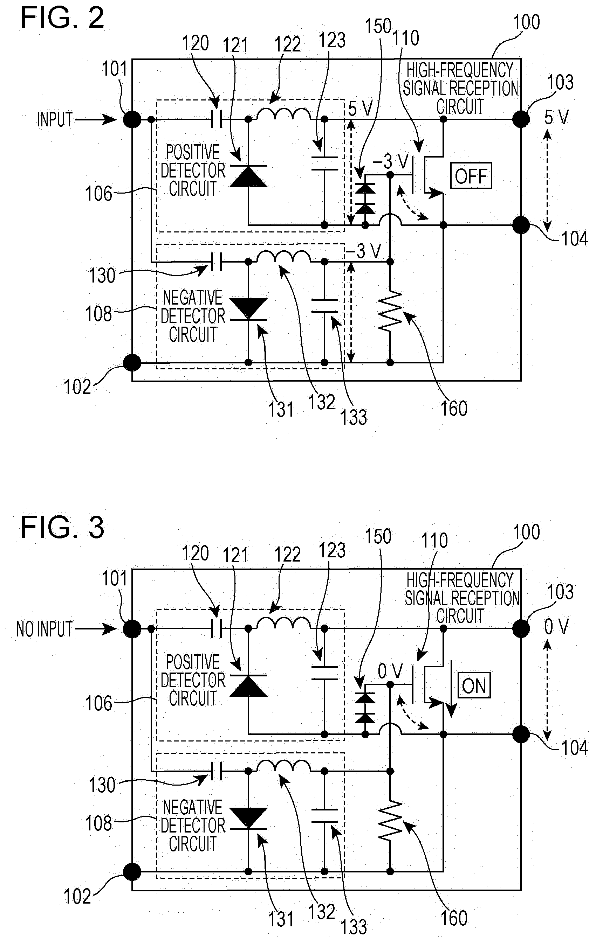

Next, an example of operation of the high-frequency signal reception circuit 100 will be described using FIGS. 2 and 3. The high-frequency signal reception circuit 100 outputs a positive voltage or a 0 V voltage between the output reference terminal 104 and the output terminal 103, depending on the presence or absence of a carrier wave included in an input signal input into the input terminal 101. In other words, the high-frequency signal reception circuit 100 outputs a positive voltage when the carrier wave appears in the input signal, and outputs 0 V when the carrier wave does not appear in the input signal. Particularly, when the carrier wave does not appear in the input signal, the output terminal 103 and the output reference terminal 104 enter a state equal to being connected by a low resistance of 1 Ω or less.

Note that the load connected to the high-frequency signal reception circuit 100 is a power semiconductor switching element, for example. In this case, the output terminal 103 is connected to the gate terminal of the power semiconductor switching element, while the output reference terminal 104 is connected to the source terminal of the power semiconductor switching element, for example.

In addition, by reversing the connection of the anode and the cathode of the positive diode 121, the high-frequency signal reception circuit 100 is also able to output a negative voltage or a voltage of 0 V.

In other words, it is sufficient for the high-frequency signal reception circuit 100 to be equipped with a first detector circuit that outputs an output signal, and a second detector circuit that outputs a negative voltage pulse to the control terminal of a transistor. The first detector circuit may be a circuit that outputs a positive voltage like the positive detector circuit 106 illustrated in FIG. 1, or a circuit that outputs a negative voltage. In other words, the output signal may also be a positive voltage pulse or a negative voltage pulse.

FIG. 2 is a diagram illustrating an example of the voltage of each terminal in the high-frequency signal reception circuit 100 when the carrier wave appears in the input signal input into the input terminal 101. The high-frequency signal reception circuit 100 illustrated in FIG. 2 outputs an on-voltage to the output terminal 103. An on-voltage refers to a gate voltage causing an on-state in the power semiconductor switching element to be driven.

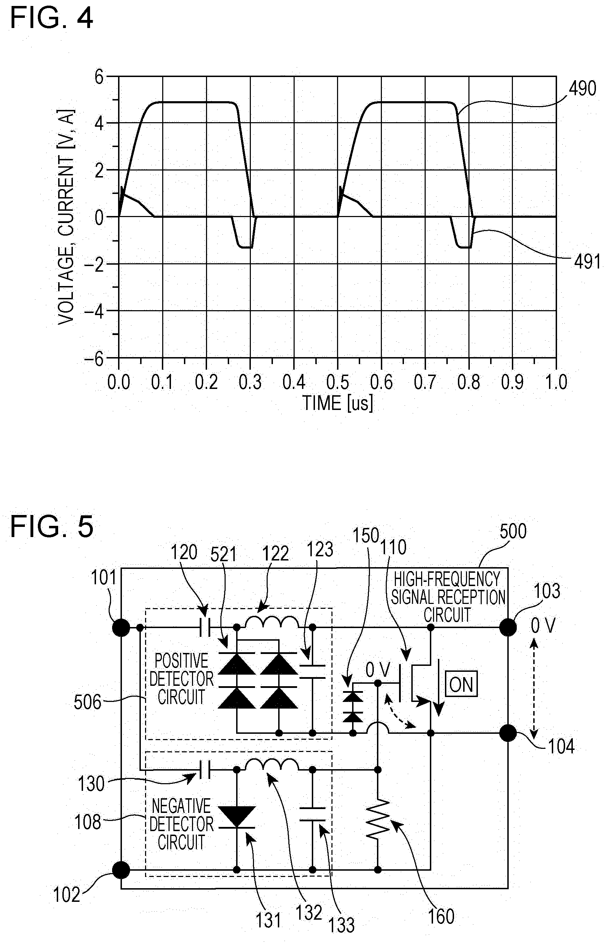

In other words, when the carrier wave is input into the input terminal 101, the positive detector circuit 106 outputs a positive voltage to the output terminal 103 using the input reference terminal 102 as a reference. In the example illustrated in FIG. 2, a voltage of +5 V is supplied from one terminal of the positive inductor 122 to the output terminal 103. Furthermore, the negative detector circuit 108 outputs a negative voltage to the gate terminal of the transistor 110, using the input reference terminal 102 as a reference. In the example illustrated in FIG. 2, a voltage of -3 v is supplied to one terminal of the negative inductor 132 and the gate terminal of the transistor 110. At this point, since the negative inductor 132 and the gate terminal of the transistor 110 are connected, a negative voltage is supplied to the gate terminal of the transistor 110, using the output reference terminal 104 as a reference. In the example illustrated in FIG. 2, -3 V is supplied to the gate terminal of the transistor 110. The supply of a negative voltage to the gate terminal of the transistor 110 causes the transistor 110 to enter an off-state. In other words, the pathway between the output terminal 103 and the output reference terminal 104 goes open, or in other words, enters a state of extremely high resistance. For this reason, a positive voltage is output from the output terminal 103 using the output reference terminal 104 as a reference. In the example illustrated in FIG. 2, +5 V is output from the output terminal 103. This positive voltage turns on the power semiconductor switching element connected to the output terminal 103 and the output reference terminal 104, for example.

Next, an example of operation when turning off the power semiconductor switching element will be described using FIG. 3. FIG. 3 is a diagram illustrating an example of the voltage of each terminal in the high-frequency signal reception circuit 100 when the carrier wave does not appear in the input signal input into the input terminal 101. The high-frequency signal reception circuit 100 illustrated in FIG. 3 outputs an off-voltage to the output terminal 103. An off-voltage refers to a gate voltage causing an off-state in the power semiconductor switching element to be driven.

At this point, neither the positive detector circuit 106 nor the negative detector circuit 108 generate a voltage. For this reason, the voltage input into the gate terminal of the transistor 110 becomes 0 V, and the normally-on type transistor 110 enters the on-state. As a result, the pathway between the drain terminal and the source terminal of the transistor 110 shorts, and the output terminal 103 and the output reference terminal 104 are shorted. In other words, the output voltage of the output terminal 103 and the output reference terminal 104 is 0 V. The electrical charge accumulated in the gate of the power semiconductor switching element in the on-state is eliminated via the transistor 110 during the process of the output terminal 103 and the output reference terminal 104 shorting. For this reason, the high-frequency signal reception circuit 100 is able to rapidly turn off the power semiconductor switching element.

Herein, if the transistor 110 is a transistor with a large gate width, there is less gate resistance when the transistor 110 is in the on-state. Meanwhile, if the transistor 110 is a transistor with a small gate width, the power and time to switch the transistor 110 from the on-state to the off-state may be decreased. For example, the transistor 110 may have a gate width of approximately 500 microns or less.

As above, when a carrier wave is input into the input terminal 101, a gate voltage for putting the power semiconductor switching element in the on-state is supplied from the output terminal 103. In addition, when a carrier wave is not input into the input terminal 101, the output terminal 103 and the output reference terminal 104 are shorted, and thus the power semiconductor switching element may be turned off. In this way, the level of the output signal may be toggled according to the presence or absence of a carrier wave in the input signal.

In this way, since the high-frequency signal reception circuit 100 is equipped with a normally-on type transistor as the transistor 110, the presence or absence of an output voltage may be toggled according to the presence or absence of a carrier wave in a single input signal. In addition, it is sufficient for an isolated signal-transmission device to be equipped with one transmitter circuit subsystem for outputting a high-frequency wave to the signal isolation element. Specifically, it is sufficient to provide one modulated signal generator circuit subsystem for outputting a modulated signal to the electromagnetic resonance coupler. For this reason, a more compact isolated signal-transmission device equipped with such a high-frequency signal reception circuit 100 may be realized. However, the present disclosure does not exclude the case of providing multiple signal isolation elements or transmitter circuits.

Also, since the high-frequency signal reception circuit 100 uses contactless power transmission, the high-frequency signal reception circuit 100 is able to a negative voltage in addition to an output voltage at the same time. By supplying the negative voltage to the gate terminal of the normally-on type transistor 110, control of the output of the high-frequency signal reception circuit 100 may be realized.

In addition, the high-frequency signal reception circuit 100 realizes the generation of an output voltage and the control of the transistor 110 at the same time with a single input signal. The merits of this configuration are as follows.

For example, suppose a method that toggles the presence or absence of output from the high-frequency signal reception circuit 100 according to only the on/off switching of the transistor 110. Such a method requires the continuous supply of an output voltage to the transistor 110. For this reason, when the transistor 110 is on, or in other words when there is no output from the high-frequency signal reception circuit 100, the power supplied to the transistor 110 is wasted. Consequently, this method is inefficient, and power consumption increases.

For example, suppose a method that uses a normally-off type transistor. With such a method, where there is no input into the high-frequency signal reception circuit 100, and thus nor output from the high-frequency signal reception circuit, a voltage for putting the transistor in the on-state becomes necessary. For this reason, two signal subsystems are required, one for the signal for generating an output voltage from the high-frequency signal reception circuit, and one for the signal that controls the transistor.

Given the above, the high-frequency signal reception circuit 100 differs from the other methods above, and is able to realize the generation of an output voltage and the control of the transistor 110 at the same time with a single input signal.

Since a normally-on type transistor is used for the transistor 110, the transistor 110 may be switched on at high speed. When a speed-up resistor 160 is disposed between the gate terminal and the source terminal of the transistor 110, the transistor 110 may be switched on at high speed. Note that the resistance value of the resistor 160 may also be reduced to switch on the transistor 110 at high speed. In this case, a large power may be generated by the negative detector circuit 108 to switch off the transistor 110.

The positive detector circuit 106 and the negative detector circuit 108 are connected to the input terminal 101. How to distribute the power of the input signal input from the input terminal 101 between the positive detector circuit 106 and the negative detector circuit 108 is decided by the ratio of the positive coupling capacitor 120 and the negative coupling capacitor 130. If too much power is distributed to the negative detector circuit 108 for turning off the transistor 110, the voltage generated and output by the positive detector circuit 106 will be reduced. Accordingly, the positive coupling capacitor 120 may be the same as or greater than the negative coupling capacitor 130.

Furthermore, when a diode 150 for potential adjustment is inserted between the gate terminal and the source terminal of the transistor 110, when a large negative voltage is output from the negative detector circuit 108, the voltage is supplied to the output reference terminal 104 via the diode 150. As a result, a reduction in the voltage output from the output terminal 103 when a large voltage is input into the negative detector circuit 108, or a loss of voltage output from the output terminal 103 when a large voltage is input into the negative detector circuit 108, may be prevented.

FIG. 4 is an example of temporal waveforms of the output voltage 490 and the output current 491 of the high-frequency signal reception circuit 100. As illustrated in FIG. 4, the output voltage is toggled between 5 V and 0 V according to the presence or absence of a carrier wave in the input signal.

Note that the high-frequency signal reception circuit 100 generates a positive voltage and a ground potential, depending on the presence or absence of a carrier wave in a single input signal input from a single signal isolation element. By providing the electromagnetic resonance coupler 180 as the signal isolation element, the high-frequency signal reception circuit 100 is able to realize the above with a simple configuration. For example, when the high-frequency signal reception circuit is equipped with a transformer as the signal isolation element, the above cannot be realized with a simple configuration like the high-frequency signal reception circuit 100.

For example, suppose that an isolated signal-transmission device of the related art supplies a negative voltage for switching on a power semiconductor switching element to the gate terminal of the power semiconductor switching element. In this case, the isolated signal-transmission device requires a signal isolation element that transmits power for putting the power semiconductor switching element in the on-state, as well as a signal isolation element that transmits power for putting the power semiconductor switching element in the off-state. In other words, the isolated signal-transmission device is equipped with two signal isolation elements, the circuit becomes complicated, and the size increases. In contrast, an isolated signal-transmission device according to the present embodiment may be equipped with at least one signal isolation element, and may be compactly realized.

In addition, as above, when a negative voltage for switching on a power semiconductor switching element is supplied to the gate terminal of the power semiconductor switching element, current flows according to the relevant negative voltage. However, with an isolated signal-transmission device of the related art, since a large current is difficult to flow, switching the power semiconductor switching element from the on-state to the off-state takes more time. In contrast, in the high-frequency signal reception circuit 100, switching the transistor 110 to the on-state causes the pathway between the output terminal 103 and the output reference terminal 104 to short. For this reason, a large current corresponding to the low on-resistance of the transistor 110 may flow through the transistor 110, and the power semiconductor switching element may be switched from the on-state to the off-state in a short time.

FIG. 5 is a circuit diagram illustrating an example of a configuration of a high-frequency signal reception circuit 500 according to a modification of the present embodiment. The high-frequency signal reception circuit 500 is able to output a large output voltage when the input carrier wave is large, or in other words, when the amplitude of the input signal is large. The high-frequency signal reception circuit 500 corresponds to a circuit obtained by taking the high-frequency signal reception circuit 100 illustrated in FIG. 1, and replacing the positive diode 121 with a positive diode 521 made up of multiple diodes connected in series and parallel. In other words, the positive detector circuit 506 corresponds to a circuit obtained by taking the positive detector circuit 106 illustrated in FIG. 1, and replacing the positive diode 121 with a positive diode 521 made up of multiple diodes connected in series and parallel. Herein, each of the multiple diodes constituting the positive diode 521 has a threshold voltage and on-resistance similar to the negative diode 131, for example. Consequently, the threshold voltage of the positive diode 521 is higher than the threshold voltage of the negative diode 131. Also, the on-resistance of the positive diode 521 is lower than the on-resistance of the negative diode 131.

Meanwhile, when the input carrier wave is small, or in other word when the amplitude of the input signal is small, a large negative voltage may be output from the negative detector circuit 108 to reliably turn off the transistor. When the input carrier wave is large, or in other words when the amplitude of the input signal is large, a large positive voltage may be output from the positive detector circuit, while in addition, a comparatively small negative voltage may be output from the negative detector circuit, to cause the appropriate output of an output voltage from the high-frequency signal reception circuit 500.

Like the high-frequency signal reception circuit 500, if the positive diode 521 is made up of multiple diodes connected in series and parallel, the positive diode 521 has a high threshold voltage and a low on-resistance compared to the negative diode 131, for example. Herein, the threshold voltage of the positive diode 521 means the minimum input voltage at which a positive voltage may be output from the positive detector circuit 506 when a voltage is input into the positive diode 521. By taking such a configuration, until the voltage of the input signal exceeds the threshold voltage of the positive diode 521, a signal is not output from the positive detector circuit 506 and thus only the negative detector circuit 108 performs a detection operation. In other words, when the input signal is small, the high-frequency signal reception circuit 500 does not output an output signal. On the other hand, as the voltage of the input signal increases, the input signal is detected by the positive diode 521, and in addition, because of the small on-resistance of the positive diode 521, the positive detector circuit 506 is able to output a large positive voltage. In other words, when the input signal is large, the high-frequency signal reception circuit 500 is able to output an output signal. Consequently, a high-frequency signal reception circuit 500 that operates appropriately depending on the magnitude of the input signal is realized.

Note that in the high-frequency signal reception circuit 500, the threshold voltage of the positive diode 521 is higher than the threshold voltage of the negative diode 131, and in addition, the on-resistance of the positive diode 521 is lower than the on-resistance of the negative diode 131, but it is also possible for just one of the above to be satisfied. As a result, the rising voltage of the positive detector circuit 506 increases, or the positive output voltage from the positive detector circuit 506 increases.

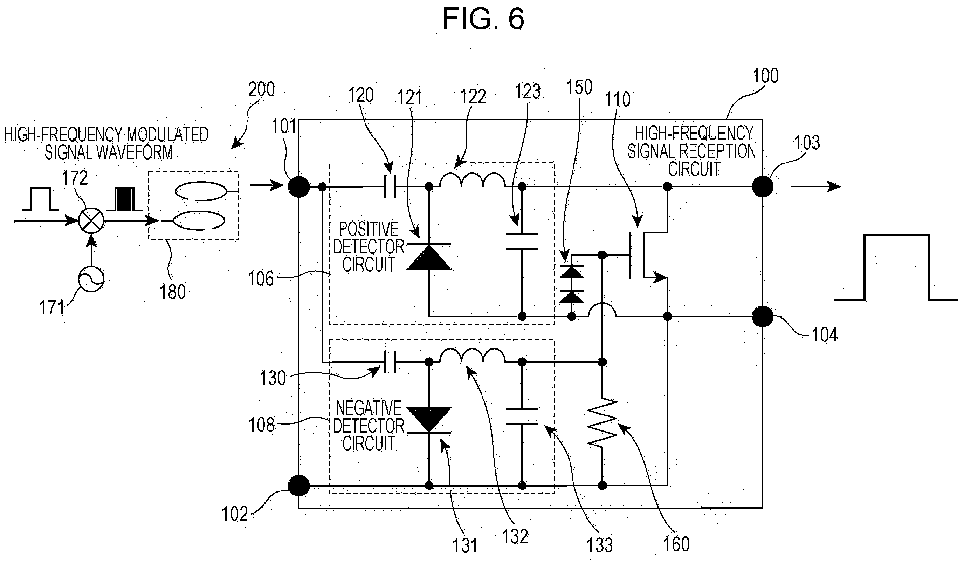

FIG. 6 is an example of a circuit diagram of an isolated signal-transmission device 200.

The isolated signal-transmission device 200 is a circuit used as a gate driver circuit or the like of a semiconductor switching element, for example. The isolated signal-transmission device 200 corresponds to a configuration obtained by replacing the modulated signal generator circuit 170 with an oscillator 171 and a modulator 172 in the isolated signal-transmission device illustrated in FIG. 1. In other words, the isolated signal-transmission device 200 is a device that performs isolated transmission of an input signal, and is equipped with an oscillator 171 that generates a high-frequency wave to act as the carrier wave, a modulator 172 that uses a pulse signal to modulate the carrier wave generated by the oscillator 171, an electromagnetic resonance coupler 180 that uses electromagnetic resonance to perform isolated transmission of the modulated signal obtained by the modulator 172, and the high-frequency signal reception circuit 100 that detects a signal output from the electromagnetic resonance coupler 180 as the input signal.

The oscillator 171 generates a high-frequency wave having a frequency of 100 MHz or more as the carrier wave, for example.

The modulator 172 is a circuit that uses a pulse signal to modulate the carrier wave generated by the oscillator 171, and generates a modulated signal. The modulator 172 may also be a mixer that mixes the carrier wave and the pulse signal, for example. The modulator 172 may also be a switch or the like that controls whether the carrier wave is passed through or blocked, depending on the pulse signal, for example.

Note that although FIG. 6 illustrates a waveform of the modulated signal with components having voltage values of 0 V or greater, the input signal may also have a waveform with components having voltage values of less than 0. The input signal expresses a waveform that is sign-symmetric about a reference of 0 V in the envelope curve, for example.

In the isolated signal-transmission device 200 equipped with such a configuration, an input pulse signal is converted to a modulated signal by the modulator 172, transmitted by contactless transmission by the electromagnetic resonance coupler 180, detected by the high-frequency signal reception circuit 100, and output as a gate driving signal for a power semiconductor switching element, for example.

Note that in the high-frequency signal reception circuits 100 and 500, the positive diode 121 and the negative diode 131 may also be diodes with a small junction capacitance that operate at high frequency. Such diodes are Schottky barrier diodes, for example.

In the high-frequency signal reception circuits 100 and 500, the load connected to the output terminal 103 and the output reference terminal 104 is described as a GaN switching device that turns on at a gate voltage of 3 V. However, the high-frequency signal reception circuits 100 and 500 may also be connected to some other power semiconductor switching element.

In the high-frequency signal reception circuits 100 and 500, when the high-frequency wave is 2.4 GHz, for example, GaN Schottky barrier diodes may be used as the positive diode 121 and the negative diode 131. In this case, by taking the inductance of the positive inductor 122 and the negative inductor 132 to be 5.8 nH, and the capacitance of the positive coupling capacitor 120 and the negative coupling capacitor 130 to be 0.7 pF, for example, the positive detector circuit 106 and the negative detector circuit 108 operate as 2.4 GHz detector circuits.

Since such an isolated signal-transmission device 200 is equipped with the electromagnetic resonance coupler 180, the primary side in which the input signal is generated and the secondary side in which the input signal is generated are isolated, and in addition, the rising time of the output signal may be shortened. Furthermore, since the isolated signal-transmission device 200 is equipped with the high-frequency signal reception circuit 100, the falling time of the output signal may be shortened. Consequently, the isolated signal-transmission device 200 is able to transmit a high-speed signal in a contactless manner, and drive a semiconductor switching element at high speed.

Furthermore, the modulator and the signal isolation element on the input side of the high-frequency signal reception circuit 100 are able to output an input signal common to both the positive detector circuit 106 and the negative detector circuit 108. For this reason, the isolated signal-transmission device 200 may be realized with a single circuit subsystem of a modulator and a signal isolation element. Consequently, the isolated signal-transmission device 200 becomes more compact.

The foregoing thus describes a high-frequency signal reception circuit and an isolated signal-transmission device according to the present disclosure, on the basis of an embodiment. However, the present disclosure is not limited to the foregoing embodiment. Embodiments obtained by applying various modifications that may occur to persons skilled in the art as well as embodiments constructed by combining the structural elements in different embodiments may also be included within the scope of the one or more exemplary embodiments of the present disclosure, insofar as such embodiments do not depart from the spirit of the present disclosure.

For example, the isolated signal-transmission device 200 illustrated in FIG. 6 is equipped with the high-frequency signal reception circuit 100 illustrated in FIG. 1, but an isolated signal-transmission device may also be equipped with the high-frequency signal reception circuit 500 illustrated in FIG. 5.

In addition, the isolated signal-transmission device 200 is equipped with the electromagnetic resonance coupler 180 as a signal isolation element, but instead of an electromagnetic resonance coupler, another element that provides isolated transmission of a high-frequency wave may also be provided.

In addition, in the high-frequency signal reception circuits 100 and 500, the transistor 110 is an N-channel transistor, but may also be a P-channel transistor. In this case, the source terminal of the P-channel transistor is connected to the output terminal 103, the drain terminal is connected to the output reference terminal 104, and the gate terminal is connected to the negative detector circuit 108.

For example, a high-frequency signal reception circuit is a high-frequency signal reception circuit that detects an input signal, which is a signal obtained by modulating a carrier wave with a pulse signal. The high-frequency signal reception circuit includes: an input terminal and an input reference terminal for receiving the input signal, an output terminal and an output reference terminal for outputting a pulse signal after detection, a positive detector circuit that detects the input signal, and outputs a pulse signal of positive voltage to the output terminal using the output reference terminal as a reference; a normally-on type transistor having a first terminal connected to the output terminal, a second terminal connected to the output reference terminal, and a control terminal; and a negative detector circuit that detects the input signal, and outputs a pulse signal of negative voltage to the control terminal of the transistor using the output reference terminal as a reference.

For example, the input signal is a signal expressed by the presence or absence of a carrier wave, whereby the negative detector circuit outputs to the control terminal of the transistor a pulse signal that takes a negative voltage when the carrier wave appears in the input signal, and takes a reference voltage when the carrier wave does not appear in the input signal, while the transistor turns off when the negative voltage is input from the negative detector circuit, and turns on when the reference voltage is input from the negative detector circuit.

Note that the circuit configuration illustrated in the foregoing description and the drawings is an example, and the present disclosure is not limited to the foregoing circuit configuration. In other words, a circuit able to realize the characteristic functions of the present disclosure similarly to the foregoing circuit configuration is also included in the present disclosure. For example, the present disclosure also includes configurations in which an element such as a switching element (transistor), resistive element, or capacitive element is connected to a given element in series or parallel, within a range that still enables the realization of functions similar to the foregoing circuit configuration. In other words, the term "connected" in the foregoing description is not limited to the case of two terminals (leads) being connected directly, and also encompasses the case of the two terminals (leads) being connected via an element, insofar as similar functionality may be realized.

In addition, in the present disclosure, terms related to the input and output of a signal are not limited to the case of the signal being input or output directly, and also encompass the case of the signal being input or output indirectly. For example, phrases such as "the signal is output from A to B", "the signal is input from A into B", and "the signal is output from A and input into B" also encompass configurations that include some other element or circuit between A and B. Additionally, such phrases also encompass a signal being output from A, modified via some other element or circuit, and then input into B.

### Industrial Applicability

A high-frequency signal reception circuit and an isolated signal-transmission device according to the present disclosure is useful as a gate driver circuit that drives a semiconductor switching element.

### Reference Signs List

- 100, 500: high-frequency signal reception circuit
- 101: input terminal
- 102: input reference terminal
- 103: output terminal
- 104: output reference terminal
- 106, 506: positive detector circuit
- 108: negative detector circuit
- 110: transistor
- 120: positive coupling capacitor
- 121, 521: positive diode
- 122: positive inductor
- 123: positive smoothing capacitor
- 130: negative coupling capacitor
- 131: negative diode
- 132: negative inductor
- 133: negative smoothing capacitor
- 150: diode
- 160: resistor
- 170: modulated signal generator circuit
- 171: oscillator
- 172: modulator
- 180: electromagnetic resonance coupler
- 200: isolated signal-transmission device
- 490: output voltage
- 491: output current

## Claims

1. A high-frequency signal reception circuit (100, 500) that detects an input signal, the input signal being a signal obtained by modulating a carrier wave with a pulse signal, the high-frequency signal reception circuit (100, 500) comprising:
an input terminal (101) and an input reference terminal (102) for receiving the input signal;
an output terminal (103) and an output reference terminal (104) for outputting an output signal after detection;
a first detector circuit (106, 506) that detects the input signal input between the input terminal (101) and the input reference terminal (102), and outputs an output signal to the output terminal (103) and the output reference terminal (104), the first detector circuit (106, 506) including a positive coupling capacitor (120) that has a first terminal connected to the input terminal (101), and a positive inductor (122) that has a first terminal connected to the second terminal of the positive coupling capacitor (120);
a normally-on type transistor (110) having a first terminal connected to the output terminal (103), a second terminal connected to the output reference terminal (104), and a control terminal; and
a second detector circuit (108) that detects the input signal input between the input terminal (101) and the input reference terminal (102), and outputs a pulse signal of negative voltage to the control terminal of the transistor (110) using the output reference terminal (104) as a reference, the second detector circuit (108) including a negative coupling capacitor (130) that has a first terminal connected to the input terminal (101), and a negative inductor (132) that has a first terminal connected to the second terminal of the negative coupling capacitor (130).

2. The high-frequency signal reception circuit (100, 500) according to claim 1, wherein
the input signal is a signal including a first amplitude, and a second amplitude greater than the first amplitude,
the second detector circuit (108), by detecting the first amplitude of the input signal, outputs a first voltage value of 0 or a negative value to the control terminal of the transistor (110) using the output reference terminal (104) as a reference, and in addition, by detecting the second amplitude of the input signal, outputs a second voltage value smaller than the first voltage value to the control terminal of the transistor (110) using the output reference terminal (104) as a reference, and thereby outputs the output signal including the first voltage value and the second voltage value, and
the transistor (110) enters an off-state when the second voltage value is input into the control terminal, and enters an on-state when the first voltage value is input into the control terminal.

3. The high-frequency signal reception circuit (100, 500) according to claim 1, wherein
the first detector circuit (106, 506) outputs, as the output signal, a pulse signal of positive voltage to the output terminal (103) using the output reference terminal (104) as a reference.

4. The high-frequency signal reception circuit (100, 500) according to any one of claims 1 to 3, further comprising:
a diode (150) connected between the control terminal of the transistor (110) and the output reference terminal (104).

5. The high-frequency signal reception circuit (100, 500) according to any one of claims 1 to 4, further comprising:
a resistor (160) connected between the control terminal of the transistor (110) and the output reference terminal (104).

6. The high-frequency signal reception circuit (100, 500) according to any one of claims 1 to 5, wherein
the first detector circuit (106, 506) further includes
a positive diode (121, 521) having a cathode connected to a second terminal of the positive coupling capacitor (120), and an anode connected to the output reference terminal (104), and
a positive smoothing capacitor (123) connected between a second terminal of the positive inductor (122) and the output reference terminal (104).

7. The high-frequency signal reception circuit (100, 500) according to any one of claims 1 to 5, wherein
the second detector circuit (108) further includes
a negative diode (131) having an anode connected to a second terminal of the negative coupling capacitor (130), and a cathode connected to the output reference terminal (104), and
a negative smoothing capacitor (133) connected between a second terminal of the negative inductor (132) and the output reference terminal (104).

8. The high-frequency signal reception circuit (100, 500) according to any one of claims 1 to 5, wherein
the first detector circuit (106, 506) further includes
a positive diode (121, 521) having a cathode connected to a second terminal of the positive coupling capacitor (120), and an anode connected to the output reference terminal (104), and
a positive smoothing capacitor (123) connected between a second terminal of the positive inductor (122) and the output reference terminal (104), and
the second detector circuit (108) further includes
a negative diode (131) having an anode connected to a second terminal of the negative coupling capacitor (130), and a cathode connected to the output reference terminal (104), and
a negative smoothing capacitor (133) connected between a second terminal of the negative inductor (132) and the output reference terminal (104).

9. The high-frequency signal reception circuit (100, 500) according to claim 8, wherein
a threshold voltage of the positive diode (121, 521) is higher than a threshold voltage of the negative diode (131).

10. The high-frequency signal reception circuit (100, 500) according to claim 8 or 9, wherein
an on-resistance of the positive diode (121, 521) is lower than an on-resistance of the negative diode (131).

11. The high-frequency signal reception circuit (100, 500) according to any one of claims 1 to 5, wherein
the input reference terminal (102) and the second terminal of the transistor (110) are electrically connected.

12. An isolated signal-transmission device (200) that performs isolated transmission of an input signal, comprising:
an oscillator (171) that generates a carrier wave;
a modulator (172) that uses a pulse signal to modulate a carrier wave generated by the oscillator (171);
an electromagnetic resonance coupler (180) that uses electromagnetic resonance to perform isolated transmission of a modulated signal obtained by the modulator (172); and
a high-frequency signal reception circuit (100, 500) according to any one of claims 1 to 11 that detects a signal output from the electromagnetic resonance coupler (180) as an input signal.

## Patentansprüche

1. Hochfrequenzsignalempfangsschaltung (100, 500), die ein Eingangssignal erfasst, wobei das Eingangssignal ein Signal ist, das durch Modulieren einer Trägerwelle mit einem Pulssignal erhalten wird, wobei die Hochfrequenzsignalempfangsschaltung (100, 500) umfasst:
einen Eingangsanschluss (101) und einen Eingangsreferenzanschluss (102) zum Empfangen des Eingangssignals,
einen Ausgangsanschluss (103) und einen Ausgangsreferenzanschluss (104) zum Ausgeben eines Ausgabesignals nach der Erfassung,
eine erste Detektorschaltung (106, 506), die das Eingangssignal erfasst, das zwischen dem Eingangsanschluss (101) und dem Eingangsreferenzanschluss (102) eingegeben wird, und ein Ausgangssignal an den Ausgangsanschluss (103) und den Ausgangsreferenzanschluss (104) ausgibt, wobei die erste Detektorschaltung (106, 506) einen positiven Kopplungskondensator (120), der einen ersten Anschluss aufweist, der mit dem Eingangsanschluss (101) verbunden ist, und einen positiven Induktor (122) aufweist, der einen ersten Anschluss aufweist, der mit dem zweiten Anschluss des positiven Kopplungskondensators (120) verbunden ist,
einen Transistor (110) des normalerweise durchgängigen Typs, der einen ersten Anschluss verbunden mit dem Ausgangsanschluss (103), einen zweiten Anschluss verbunden mit dem Ausgangsreferenzanschluss (104) und einen Steueranschluss aufweist, und
eine zweite Detektorschaltung (108), die das Eingangssignal erfasst, das zwischen dem Eingangsanschluss (101) und dem Eingangsreferenzanschluss (102) eingegeben wird, und ein Pulssignal von negativer Spannung an den Steueranschluss des Transistors (110) unter Verwendung des Ausgangsreferenzanschlusses (104) als einer Referenz ausgibt, wobei die zweite Detektorschaltung (108) einen negativen Kopplungskondensator (130), der einen ersten Anschluss verbunden mit dem Eingangsanschluss (101) aufweist, und einen negativen Induktor (132) aufweist, der einen ersten Anschluss verbunden mit dem zweiten Anschluss des negativen Kopplungskondensators (130) aufweist.

2. Hochfrequenzsignalempfangsschaltung (100, 500) nach Anspruch 1, wobei
das Eingangssignal ein Signal mit einer ersten Amplitude und einer zweiten Amplitude ist, die größer ist als die erste Amplitude,
die zweite Detektorschaltung (108) durch Erfassen der ersten Amplitude des Eingangssignals einen ersten Spannungswert von 0 oder einen negativen Wert an den Steueranschluss des Transistors (110) unter Verwendung des Ausgangsreferenzanschlusses (104) als einer Referenz ausgibt und zusätzlich durch Erfassen der zweiten Amplitude des Eingangssignals einen zweiten Spannungswert, der kleiner als der erste Spannungswert ist, an den Steueranschluss des Transistors (110) unter Verwendung des Ausgangsreferenzanschlusses (104) als einer Referenz ausgibt, und dadurch das Ausgangssignal mit dem ersten Spannungswert und dem zweiten Spannungswert ausgibt, und
der Transistor (110) einen Aus-Zustand annimmt, wenn der zweite Spannungswert in den Steueranschluss eingegeben wird, und einen Ein-Zustand annimmt, wenn der erste Spannungswert in den Steueranschluss eingegeben wird.

3. Hochfrequenzsignalempfangsschaltung (100, 500) nach Anspruch 1, wobei
die erste Detektorschaltung (106, 506) als das Ausgangssignal ein Pulssignal von positiver Spannung an den Ausgangsanschluss (103) unter Verwendung des Ausgangsreferenzanschlusses (104) als einer Referenz ausgibt.

4. Hochfrequenzsignalempfangsschaltung (100, 500) nach einem der Ansprüche 1 bis 3, ferner mit:
einer Diode (150), die zwischen dem Steueranschluss des Transistors (110) und dem Ausgangsreferenzanschluss (104) verbunden ist.

5. Hochfrequenzsignalempfangsschaltung (100, 500) nach einem der Ansprüche 1 bis 4, ferner mit:
einem Widerstand (160), der zwischen dem Steueranschluss des Transistors (110) und dem Ausgangsreferenzanschluss (104) verbunden ist.

6. Hochfrequenzsignalempfangsschaltung (100, 500) nach einem der Ansprüche 1 bis 5, wobei
die erste Detektorschaltung (106, 506) ferner umfasst:
eine positive Diode (102, 521) mit einer mit einem zweiten Anschluss des positiven Kopplungskondensators (120) verbundenen Kathode und einer mit dem Ausgangsreferenzanschluss (104) verbundenen Anode und
einen positiven Glättungskondensator (123), der zwischen einem zweiten Anschluss des positiven Induktors (122) und dem Ausgangsreferenzanschluss (104) verbunden ist.

7. Hochfrequenzsignalempfangsschaltung (100, 500) nach einem der Ansprüche 1 bis 5, wobei
die zweite Detektorschaltung (108) ferner umfasst:
eine negative Diode (131) mit einer mit einem zweiten Anschluss des negativen Kopplungskondensators (130) verbundenen Anode und einer mit dem Ausgangsreferenzanschluss (104) verbundenen Kathode und
einen negativen Glättungskondensator (133), der zwischen einem zweiten Anschluss des negativen Induktors (132) und dem Ausgangsreferenzanschluss (104) verbunden ist.

8. Hochfrequenzsignalempfangsschaltung (100, 500) nach einem der Ansprüche 1 bis 5, wobei
die erste Detektorschaltung (106, 506) ferner umfasst:
eine positive Diode (121, 521) mit einer mit einem zweiten Anschluss des positiven Kopplungskondensators (120) verbundenen Kathode und einer mit dem Ausgangsreferenzanschluss (104) verbundenen Anode und
einen positiven Glättungskondensator (123), der zwischen einem zweiten Anschluss des positiven Induktors (122) und dem Ausgangsreferenzanschluss (104) verbunden ist, und
die zweite Detektorschaltung (108) ferner umfasst:
eine negative Diode (131) mit einer mit einem zweiten Anschluss des negativen Kopplungskondensators (130) verbundenen Anode und einer mit dem Ausgangsreferenzanschluss (104) verbundenen Kathode und
einen negativen Glättungskondensator (133), der zwischen einem zweiten Anschluss des negativen Induktors (132) und dem Ausgangsreferenzanschluss (104) verbunden ist.

9. Hochfrequenzsignalempfangsschaltung (100, 500) nach Anspruch 8, wobei
eine Schwellenspannung der positiven Diode (121, 521) höher ist als eine Schwellenspannung der negativen Diode (131).

10. Hochfrequenzsignalempfangsschaltung (100, 500) nach Anspruch 8 oder 9, wobei
ein Ein-Widerstand der positiven Diode (121, 521) geringer ist als ein Ein-Widerstand der negativen Diode (131).

11. Hochfrequenzsignalempfangsschaltung (100, 500) nach einem der Ansprüche 1 bis 5, wobei
der Eingangsreferenzanschluss (102) und der zweite Anschluss des Transistors (110) elektrisch verbunden sind.

12. Isolierte Signalübermittlungsvorrichtung (200), die eine isolierte Übermittlung eines Eingangssignals durchführt, mit:
einem Oszillator (171), der eine Trägerwelle erzeugt,
einem Modulator (172), der ein Pulssignal verwendet, um eine Trägerwelle zu modulieren, die durch den Oszillator (171) erzeugt wurde,
einem elektromagnetischen Resonanzkoppler (180), der elektromagnetische Resonanz zum Durchführen einer isolierten Übermittlung eines modulierten Signals verwendet, das durch den Modulator (172) erhalten wurde, und
einer Hochfrequenzsignalempfangsschaltung (100, 500) nach einem der Ansprüche 1 bis 11, die ein Signal als ein Eingangssignal erfasst, das von dem elektromagnetischen Resonanzkoppler (180) ausgegeben wurde.

## Revendications

1. Circuit de réception de signal haute fréquence (100, 500) qui détecte un signal d'entrée, le signal d'entrée étant un signal obtenu en modulant une onde porteuse avec un signal impulsionnel, le circuit de réception de signal haute fréquence (100, 500) comprenant:
une borne d'entrée (101) et une borne de référence d'entrée (102) pour recevoir le signal d'entrée,
une borne de sortie (103) et une borne de référence de sortie (104) pour délivrer un signal de sortie après la détection,
un premier circuit détecteur (106, 506) qui détecte le signal d'entrée entré entre la borne d'entrée (101) et la borne de référence d'entrée (102) et qui délivre un signal de sortie à la borne de sortie (103) et à la borne de référence de sortie (104), le premier circuit détecteur (106, 506) comprenant un condensateur de couplage positif (120) qui présente une première borne connectée à la borne d'entrée (101), et un inducteur positif (122) qui présente une première borne connectée à la deuxième borne du condensateur de couplage positif (120),
un transistor (110) de type normalement passant qui présente une première borne connectée à la borne de sortie (103), une deuxième borne connectée à la borne de référence de sortie (104) et une borne de commande, et
un deuxième circuit détecteur (108) qui détecte le signal d'entrée entré entre la borne d'entrée (101) et la borne de référence d'entrée (102), et qui délivre un signal impulsionnel de tension négative à la borne de commande du transistor (110) en utilisant la borne de référence de sortie (104) en tant que référence, ledit deuxième circuit détecteur (108) comprenant un condensateur de couplage négatif (130) qui présente une première borne connectée à la borne d'entrée (101) et un inducteur négatif (132) qui présente une première borne connectée à la deuxième borne du condensateur de couplage négatif (130).

2. Circuit de réception de signal haute fréquence (100, 500) selon la revendication 1, dans lequel
le signal d'entrée est un signal comprenant une première amplitude et une deuxième amplitude supérieure à la première amplitude,
le deuxième circuit détecteur (108), en détectant la première amplitude du signal d'entrée, délivre une première valeur de tension de 0 ou une valeur négative à la borne de commande du transistor (110) en utilisant la borne de référence de sortie (104) en tant que référence, et, en outre, en détectant la deuxième amplitude du signal d'entrée, délivre une deuxième valeur de tension inférieure à la première valeur de tension à la borne de commande du transistor (110) en utilisant la borne de référence de sortie (104) en tant que référence, et délivre ainsi le signal de sortie comprenant la première valeur de tension et la deuxième valeur de tension, et
le transistor (110) passe à un état inactif lorsque la deuxième valeur de tension est entrée dans la borne de commande, et passe à un état actif lorsque la première valeur de tension est entrée dans la borne de commande.

3. Circuit de réception de signal haute fréquence (100, 500) selon la revendication 1, dans lequel
le premier circuit détecteur (106, 506) délivre, en tant que signal de sortie, un signal impulsionnel de tension positive à la borne de sortie (103) en utilisant la borne de référence de sortie (104) en tant que référence.

4. Circuit de réception de signal haute fréquence (100, 500) selon l'une quelconque des revendications 1 à 3, comprenant en outre:
une diode (150) connectée entre la borne de commande du transistor (110) et la borne de référence de sortie (104).

5. Circuit de réception de signal haute fréquence (100, 500) selon l'une quelconque des revendications 1 à 4, comprenant en outre:
une résistance (160) connectée entre la borne de commande du transistor (110) et la borne de référence de sortie (104).

6. Circuit de réception de signal haute fréquence (100, 500) selon l'une quelconque des revendications 1 à 5, dans lequel
le premier circuit détecteur (106, 506) comprend en outre:
une diode positive (121, 521) comprenant une cathode qui est connectée à une deuxième borne du condensateur de couplage positif (120) et une anode qui est connectée à la borne de référence de sortie (104), et
un condensateur de lissage positif (123) qui est connecté entre une deuxième borne de l'inducteur positif (122) et la borne de référence de sortie (104).

7. Circuit de réception de signal haute fréquence (100, 500) selon l'une quelconque des revendications 1 à 5, dans lequel
le deuxième circuit détecteur (108) comprend en outre:
une diode négative (131) comprenant une anode qui est connectée à une deuxième borne du condensateur de couplage négatif (130) et une cathode qui est connectée à la borne de référence de sortie (104), et
un condensateur de lissage négatif (133) qui est connecté entre une deuxième borne de l'inducteur négatif (132) et la borne de référence de sortie (104).

8. Circuit de réception de signal haute fréquence (100, 500) selon l'une quelconque des revendications 1 à 5, dans lequel
le premier circuit détecteur (106, 506) comprend en outre:
une diode positive (121, 521) comprenant une cathode qui est connectée à une deuxième borne du condensateur de couplage positif (120) et une anode qui et connectée à la borne de référence de sortie (104), et
un condensateur de lissage positif (123) qui est connecté entre une deuxième borne de l'inducteur positif (122) et la borne de référence de sortie (104), et
le deuxième circuit détecteur (108) comprend en outre:
une diode négative (131) comprenant une anode qui est connectée à une deuxième borne du condensateur de couplage négatif (130) et une cathode qui est connectée à la borne de référence de sortie (104), et
un condensateur de lissage négatif (133) qui est connecté entre une deuxième borne de l'inducteur négatif (132) et la borne de référence de sortie (104).

9. Circuit de réception de signal haute fréquence (100, 500) selon la revendication 8, dans lequel
une tension de seuil de la diode positive (121, 521) est supérieure à une tension de seuil de la diode négative (131).

10. Circuit de réception de signal haute fréquence (100, 500) selon la revendication 8 ou 9, dans lequel
une résistance ON de la diode positive (121, 521) est inférieure à une résistance ON de la diode négative (131).

11. Circuit de réception de signal haute fréquence (100, 500) selon l'une quelconque des revendications 1 à 5, dans lequel
la borne de référence d'entrée (102) et la deuxième borne du transistor (110) sont connectées électriquement.

12. Dispositif de transmission de signal isolée (200) qui met en oeuvre une transmission isolée d'un signal d'entrée, comprenant:
un oscillateur (171) qui génère une onde porteuse,
un modulateur (172) qui utilise un signal impulsionnel pour moduler une onde porteuse générée par l'oscillateur (171),
un coupleur à résonance électromagnétique (180) qui utilise de la résonance électromagnétique pour effectuer une transmission isolée d'un signal modulé obtenu par le modulateur (172), et
un circuit de réception de signal haute fréquence (100, 500) selon l'une quelconque des revendications 1 à 11, qui détecte, en tant que signal d'entrée, un signal délivré du coupleur à résonance électromagnétique (180).
